# EUROPEAN PATENT SPECIFICATION

(11) **EP 4 242 701 B1**
(45) Date of publication and mention of the grant of the patent: **07.10.2026**
(21) Application number: 20963616.6
(22) Date of filing: 30.11.2020
(51) Int. Cl.: H10F 39/00, H10F 39/18

(54) **OPTICAL ELEMENT, IMAGING ELEMENT, AND IMAGING DEVICE**
OPTISCHES ELEMENT, BILDGEBUNGSELEMENT UND BILDGEBUNGSVORRICHTUNG
ÉLÉMENT OPTIQUE, ÉLÉMENT D'IMAGERIE ET DISPOSITIF D'IMAGERIE

(43) Date of publication of application: 13.09.2023
(73) Proprietor: NTT, Inc., Tokyo 100-8116 (JP)
(72) Inventor: MIYATA, Masashi, Musashino-shi, Tokyo 180-8585 (JP); NEMOTO, Naru, Musashino-shi, Tokyo 180-8585 (JP); KOBAYASHI, Fumihide, Musashino-shi, Tokyo 180-8585 (JP); HASHIMOTO, Toshikazu, Musashino-shi, Tokyo 180-8585 (JP)
(74) Representative: Hoffmann Eitle
(86) International application number: PCT/JP2020/044530
(87) International publication number: WO 2022/113352

(56) References cited:
- EP-A1- 3 812 801
- WO-A1-2020/066738
- JP-A- 2010 156 942
- JP-A- 2011 040 441
- JP-A- 2015 028 960
- JP-A- 2018 146 750
- JP-A- 2019 184 986
- US-A1- 2007 146 531
- US-A1- 2008 272 454

## Description

### Technical Field

The present invention relates to an imaging element, and an imaging device.

### Background Art

A general imaging device uses a lens optical system and a two-dimensional imaging element such as a charge coupled device (CCD) sensor or a complementary metal oxide semiconductor (CMOS) sensor to acquire a two-dimensional image including intensity information and color information of light from an imaging target.

An imaging element of a conventional color sensor generally has a configuration in which incident light transmitted through an imaging lens is condensed by a microlens, and a color filter for each color is arranged on each pixel to cause a photoelectric conversion element to receive only light having a specific wavelength.

### Citation List

### Non Patent Literature

Non Patent Literature 1: Takanori Kudo, Yuki Nanjo, Yuko Nozaki, Kazuya Nagao, Hidemasa Yamaguchi, Wen-Bing Kang, Georg Pawlowski, "PIGMENTED PHOTORESISTS FOR COLOR FILTERS", Journal of Photopolymer Science and Technology, 1996, Vol. 9, No. 1, p.109-119.

### Patent Literature

US 2007/0146531 A1 describes a light collecting device for collecting incident light at a high incident angle. A first pixel may be provided for a first colour and a second pixel may be provided for a second colour. Different colour filters are provided for filtering incident light to the first and second pixel, respectively.

Document D2, US 2008/0272454 A1 refers to a light collecting device with a short focal length for a large incident angle. Separate colour filters are provided for filtering incident light for each of different pixels for the different colours.

### Summary of Invention

### Technical Problem

However, since the incident angle of the incident light passing through the imaging lens is different between a central portion and a peripheral portion of the sensor, the mode of light condensation by the microlens is also different between the central portion and the peripheral portion, and there is a problem that the light receiving sensitivity is deteriorated in the peripheral portion of the sensor.

The present invention has been made in view of the above, and an object thereof is to provide an imaging element, and an imaging device capable of improving light receiving sensitivity in a sensor peripheral portion.

### Solution to Problem

The object of the invention is solved by the subject matter of the independent claims. Advantageous embodiments of the invention are disclosed in the dependent claims. According to an example , an optical element includes a transparent layer for covering a plurality of pixels each including a photoelectric conversion element, and a plurality of structure bodies arranged on the transparent layer or in the transparent layer in a plane direction of the transparent layer, in which the plurality of structure bodies is arranged in such a manner that, among incident light, light of a first color is condensed on a first pixel located immediately below, and light of a second color is condensed on a second pixel located immediately below according to an incident angle of incident light of each of the structure bodies.

Further, an imaging element according to an example includes the above-described optical element, and the plurality of pixels covered with the transparent layer.

Further, an imaging device according to an example includes the imaging element described above, and a signal processing unit that processes an electric signal output from the image element and generates an image.

### Advantageous Effects of Invention

According to the present invention, light receiving sensitivity in a sensor peripheral portion can be improved.

### Brief Description of Drawings

Fig. 1 is a side view illustrating a schematic configuration of an imaging device according to a first embodiment.
Fig. 2 is a view schematically illustrating a part of cross sections of a pixel array and a polarization wavelength separation lens array of an imaging element according to the first embodiment.
Fig. 3 is a view schematically illustrating a part of cross sections of the pixel array and an optical element array in a central portion of the imaging element according to the first embodiment.
Fig. 4 is a view schematically illustrating a part of the cross sections of the pixel array and the optical element array in an outer peripheral portion of the imaging element according to the first embodiment.
Fig. 5 is a view illustrating an example of a schematic configuration of a structure body.
Fig. 6 is a view illustrating an example of a schematic configuration of the structure body.
Fig. 7 is a view illustrating an example of a schematic configuration of a structure body.
Fig. 8 is a view illustrating an example of a schematic configuration of the structure body.
Fig. 9 is a view illustrating an example of a schematic configuration of a structure body.
Fig. 10 is a view illustrating an example of a schematic configuration of a structure body.
Fig. 11 is a diagram illustrating an example of combinations of wavelengths and optical phase delay amounts.
Fig. 12 is a view describing a definition of an incident angle.
Fig. 13 is a diagram illustrating an example of a lens design in a case where the structure bodies are SiN.
Fig. 14 is a diagram illustrating an example of the lens design in the case where the structure bodies are SiN.
Fig. 15 is a diagram illustrating an example of the lens design in the case where the structure bodies are SiN.
Fig. 16 is a view illustrating an example of the lens design in the case where the structure bodies are SiN.
Fig. 17 is a view schematically illustrating a pixel arrangement of a pixel unit in a pixel array.
Fig. 18 is a view describing the definition of the incident angle.
Fig. 19 is a diagram illustrating an example of incident angle dependency of received light intensity in a pixel.
Fig. 20 is a diagram illustrating an example of the incident angle dependency of the received light intensity in a pixel.
Fig. 21 is a diagram illustrating an example of the incident angle dependency of the received light intensity in a pixel.
Fig. 22 is a diagram illustrating an example of the incident angle dependency of the received light intensity in a pixel.
Fig. 23 is a diagram illustrating an example of the incident angle dependency of the received light intensity in the pixel.
Fig. 24 is a diagram illustrating an example of the incident angle dependency of the received light intensity in the pixel.
Fig. 25 is a diagram illustrating an example of the incident angle dependency of the received light intensity in the pixel.
Fig. 26 is a diagram illustrating an example of the incident angle dependency of the received light intensity in the pixel.
Fig. 27 is a diagram illustrating an example of the incident angle dependency of the received light intensity in the pixel.
Fig. 28 is a diagram illustrating an example of the incident angle dependency of the received light intensity in the pixel.
Fig. 29 is a diagram illustrating an example of the incident angle dependency of the received light intensity in the pixel.
Fig. 30 is a diagram illustrating an example of the incident angle dependency of the received light intensity in the pixel.
Fig. 31 is a view schematically illustrating another example of a part of the cross sections of the pixel array and the optical element array in the imaging element according to the first embodiment.
Fig. 32 is a view schematically illustrating another example of a part of the cross sections of the pixel array and the optical element array in the imaging element according to the first embodiment.
Fig. 33 is a view illustrating an example of cross-sectional shapes of structure bodies.
Fig. 34 is a view schematically illustrating a part of cross sections of a pixel array and an optical element array in a central portion of an imaging element according to a second embodiment.
Fig. 35 is a view schematically illustrating a part of cross sections of the pixel array and the optical element array in the central portion of the imaging element according to the second embodiment.
Fig. 36 is a view schematically illustrating a pixel arrangement of pixel units in the pixel array.
Fig. 37 is a view describing the definition of the incident angle.
Fig. 38 is a diagram illustrating an example of incident angle dependency of received light intensity in a pixel.
Fig. 39 is a diagram illustrating an example of the incident angle dependency of the received light intensity in a pixel.
Fig. 40 is a diagram illustrating an example of the incident angle dependency of the received light intensity in a pixel.
Fig. 41 is a diagram illustrating an example of the incident angle dependency of the received light intensity in a pixel.
Fig. 42 is a diagram illustrating an example of the incident angle dependency of the received light intensity in the pixel.
Fig. 43 is a diagram illustrating an example of the incident angle dependency of the received light intensity in the pixel.
Fig. 44 is a diagram illustrating an example of the incident angle dependency of the received light intensity in the pixel.
Fig. 45 is a diagram illustrating an example of the incident angle dependency of the received light intensity in the pixel.
Fig. 46 is a diagram illustrating an example of the incident angle dependency of the received light intensity in the pixel.
Fig. 47 is a diagram illustrating an example of the incident angle dependency of the received light intensity in the pixel.
Fig. 48 is a diagram illustrating an example of the incident angle dependency of the received light intensity in the pixel.
Fig. 49 is a diagram illustrating an example of the incident angle dependency of the received light intensity in the pixel.
Fig. 50 is a view schematically illustrating another pixel arrangement of the pixel unit in the pixel array.

### Description of Embodiments

Hereinafter, best modes for carrying out the present invention will be described in detail with reference to the drawings. Note that, in the following description, each drawing merely schematically illustrates a shape, a size, and a positional relationship to such an extent that the contents of the present invention can be understood, and therefore the present invention is not limited only to the shape, the size, and the positional relationship exemplified in the drawings. Further, in the description of the drawings, the same portions are denoted by the same reference signs.

### [First embodiment]

### [Imaging device]

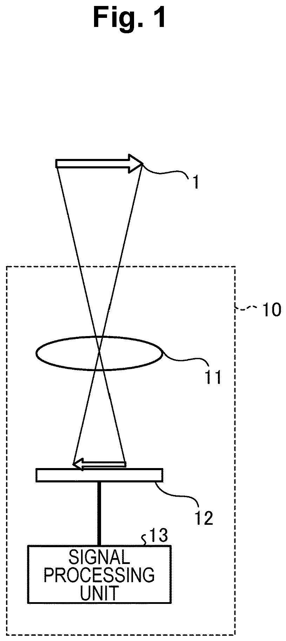

First, an imaging device according to a first embodiment of the present invention will be described. Fig. 1 is a side view illustrating a schematic configuration of an imaging device according to the first embodiment.

As illustrated in Fig. 1, an imaging device 10 according to the first embodiment includes a lens optical system 11, an imaging element 12, and a signal processing unit 13. The imaging element 12 includes a photoelectric conversion element such as a CCD or a CMOS. The signal processing unit 13 processes a photoelectric conversion signal output from the imaging element 12 to generate an image signal.

The object 1 is irradiated with light such as natural light or illumination light, and light transmitted/reflected/scattered by the object 1 or light emitted from the object 1 forms an optical image on the imaging element 12 by the lens optical system 11. In general, the lens optical system 11 includes a lens group including a plurality of lenses arranged along an optical axis in order to correct various optical aberrations, but in Fig. 1, the drawing is simplified and illustrated as a single lens. The signal processing unit 13 has an image signal output for transmitting the generated image signal to the outside.

Note that the imaging device 10 may include known components such as an infrared cut optical filter, an electronic shutter, a viewfinder, a power supply (battery), and a flash light, but the description thereof is not particularly necessary for understanding the present invention and thus will be omitted. Further, the above configuration is merely an example, and in the embodiment, known elements can be appropriately combined and used as components excluding the lens optical system 11, the imaging element 12, and the signal processing unit 13.

### [Imaging element]

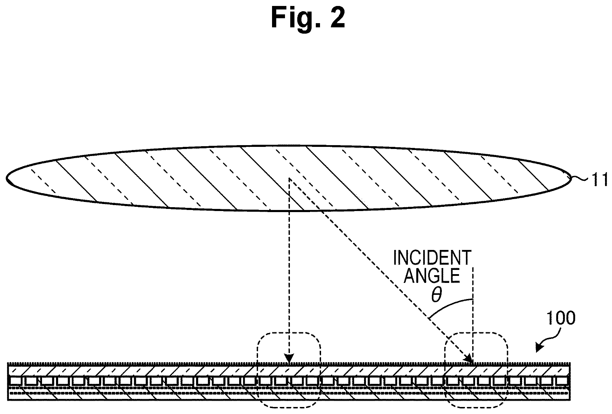

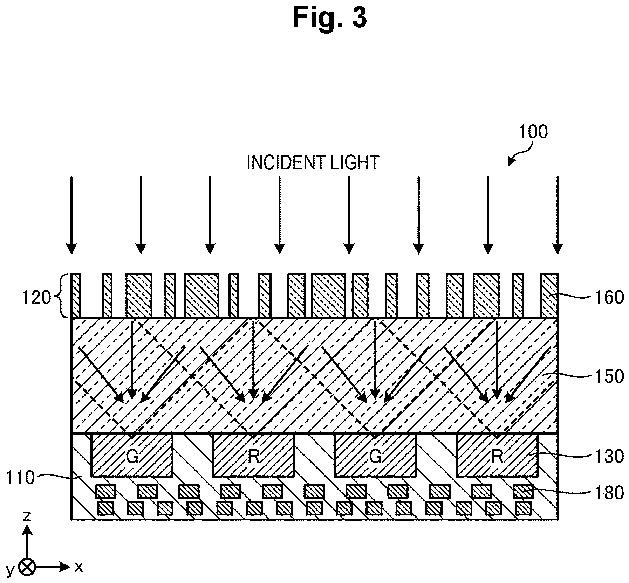

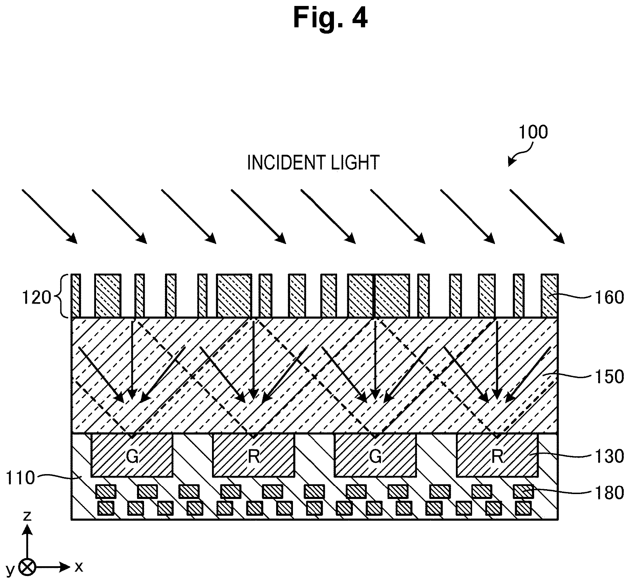

Next, an outline of the imaging element 12 according to the first embodiment will be described. Fig. 2 is a view schematically illustrating cross sections of main parts of the lens optical system 11 and the imaging element 12 according to the first embodiment. In Fig. 2 and the following, a part of the imaging element 12 will be described as an imaging element 100. The imaging element 100 has an optical element array in which a plurality of columnar structure bodies that guides incident light to photoelectric conversion elements of a pixel array is formed on the entire surface. Further, in the imaging element 100, as illustrated in Fig. 2, since the incident angle θ of light incident on the imaging element 100 from the lens optical system 11 is different between the central portion and the outer peripheral portion, a plurality of columnar structure bodies formed in the optical element array is set to a shape that gives a phase characteristic for guiding to a pixel immediately below in a state of being separated into predetermined colors according to the incident angle of the incident light. That is, the cross-sectional shape of each of the plurality of columnar structure bodies formed in the optical element array is set to be different between the central portion and the outer peripheral portion of the optical element array. Hereinafter, the structure of the imaging element 100 will be described with reference to Figs. 3 and 4.

Fig. 3 is a view schematically illustrating a part of cross sections of the pixel array and an optical element array in a central portion of the imaging element according to the embodiment. Fig. 4 is a view schematically illustrating a part of the cross sections of the pixel array and the optical element array in an outer peripheral portion of the imaging element according to the embodiment. Note that, in Figs. 3 and 4, arrows schematically indicate light incident on the imaging element 100. In the drawings, an xyz coordinate system is illustrated. An xy plane direction corresponds to a plane direction of a pixel array 110, a transparent layer 150, and the like described later. Hereinafter, unless otherwise specified, "plan view" indicates viewing in a z-axis direction (for example, in a Z-axis negative direction). "Side view" indicates viewing in an x-axis direction or a y-axis direction (for example, a y-axis negative direction).

As illustrated in Figs. 3 and 4, the imaging element 100 includes a pixel array 110 and an optical element array 120 arranged to face the pixel array 110. The pixel array 110 and the optical element array 120 are provided in this order in the z-axis positive direction. The optical element array 120 is arranged on a side on which light from the lens optical system 11 is incident. The optical element array 120 is formed on an upper surface of the transparent layer 150 formed on the pixel array 110. Note that the transparent layer 150 is a transparent layer having a low refractive index formed by a material such as SiO₂ (refractive index n = 1.45).

The pixel array 110 includes a wiring layer 180 and a plurality of pixels 130 arranged in the xy plane direction. Each pixel 130 includes a photoelectric conversion element. An example of the photoelectric conversion element is a photodiode (PD). Each pixel corresponds to red (R), green (G), and blue (B). An example of the wavelength band of red light is 600 nm < λ₀ when the wavelength is λ₀. An example of the wavelength band of green light is 500 nm < λ₀ ≤ 600 nm. An example of the wavelength band of blue light is λ₀ ≤ 500 nm. Hereinafter, each pixel is referred to as a pixel R, a pixel G, and a pixel B (not illustrated) so as to be distinguishable. The pixel R, the two pixels G, and the pixel B are arranged in a Bayer array to constitute one pixel unit as described later.

The optical element array 120 is provided so as to cover the pixel array 110. An example of the optical element array 120 is a meta-surface. The meta-surface includes a plurality of fine structure bodies (corresponding to the structure body 160) having a width equal to or less than a wavelength of light. The meta-surface may have either a two-dimensional structure or a three-dimensional structure. The optical element array 120 can control the phase and the light intensity according to light characteristics (wavelength, polarization, and incident angle) only by changing parameters of the structure body 160. In a case of the three-dimensional structure, the degree of freedom in design is improved as compared with the two-dimensional structure.

The optical element array 120 has two functions of a wavelength separation function and a lens function. The wavelength separation function is a function of separating incident light into light of each wavelength band. The lens function is a function of condensing light of each wavelength to a corresponding pixel. In this example, the incident light is separated into R light, G light, and B light by the wavelength separation function of the optical element array 120. By the lens function, the R light is condensed on the pixel R located immediately below, the G light is condensed on the pixel G located immediately below, and the B light is condensed on the pixel B located immediately below.

The optical element array 120 includes a transparent layer 150 and a plurality of columnar structure bodies 160. The transparent layer 150 is provided on the pixel array 110 so as to cover the pixel array 110. The transparent layer 150 has a refractive index lower than the refractive index of the structure bodies 160. An example of the material of the transparent layer 150 is SiO₂ or the like. The transparent layer 150 may be a void, and in this case, the refractive index of the transparent layer 150 may be equal to the refractive index of air. The material of the transparent layer 150 may be a single material or a plurality of layered materials.

The plurality of structure bodies 160 is arranged on the transparent layer 150 or in the transparent layer 150 in a plane direction (xy plane direction) of the transparent layer 150, for example, periodically (with a periodic structure). In this example, the structure bodies 160 are provided on the transparent layer 150 on the side (z-axis positive direction side) opposite to the pixel array 110 across the transparent layer 150. The plurality of structure bodies 160 may be arranged at equal intervals or may be arranged at unequal intervals for ease of design or the like. Each structure body 160 is a nano-ordered size fine structure having a dimension equal to or smaller than the wavelength of the incident light. The plurality of structure bodies 160 has the same height in side view.

The structure bodies 160 guide the incident light to the photoelectric conversion element of the corresponding pixel 130 immediately below in a state of being separated into colors. For example, in the first embodiment, a case where wavelength regions separated by the structure bodies 160 are R, G, and B will be described. The plurality of structure bodies 160 is arranged in such a manner that, among the incident light, the R color light is condensed on the pixel R located immediately below, the G light is condensed on the pixel G located immediately below, and the B light is condensed on the pixel B located immediately below according to the incident angle of the incident light of each structure body.

The structure bodies 160 are formed using a material having a refractive index higher than the refractive index of surrounding materials (transparent layer 150 and air). Thus, the structure body 160 strongly confines light inside the columnar structure body and prevents optical coupling with the adjacent columnar structure body. The structure bodies 160 are formed using, for example, SiN (refractive index n = 2.05) or TiO₂ (refractive index n = 2.40).

The structure bodies 160 are formed in shapes having phase characteristics for guiding the incident light to the photoelectric conversion elements of the corresponding pixels R, G, and B immediately below in a state of being color-separated into R, G, and B according to the incident angle of the incident light of respective columnar structure bodies in plan view. Each of the structure bodies 160 gives an optical phase delay amount according to the shape of this structure body 160 in plan view to the incident light. A cross-sectional shape of each of the structure bodies 160 is different between the central portion and the outer peripheral portion of the optical element array.

### [Structure body]

In order to achieve the structure bodies 160 having different condensing positions depending on the wavelength region of the incident light, it is necessary to achieve a structure that gives a different optical wavefront for each wavelength region. In the first embodiment, both the wavelength separation function and the light condensing function are achieved by using a wavelength dispersion characteristic of a phase delay amount given to the incident light by fine columnar structure bodies 160.

The structure bodies 160 are formed by a material such as SiN or TiO₂ having a refractive index n₁ higher than a refractive index n₀ of the transparent layer 150 or air around the structure, and heights (lengths in the z-axis direction) h of the structure bodies 160 in side view are constant. The structure bodies 160 can be considered as an optical waveguide that confines and propagates light in the structure from a refractive index difference with the transparent layer.

Therefore, when light is incident from the lens optical system 11 side, the light propagates while being strongly confined in the structure, receives a phase delay effect determined by an effective refractive index n_{eff} of the optical waveguide, and is output from the pixel array 110 side.

Specifically, when the phase of light propagated through the transparent layer by a length corresponding to a thickness of the structure is used as a reference, a phase delay amount φ by the structure bodies 160 is expressed by Expression (1) when the wavelength of the light in vacuum is λ.
[Math. 1] $φ = \left({n}_{eff}-{n}_{0}\right) \times 2 πh / λ$ (1)

Since the phase delay amount φ varies depending on the wavelength λ of light, it is possible to give different phase delay amounts depending on the wavelength region of light in the same structure body.

Furthermore, it is known that the effective refractive index n_{eff} of the optical waveguide greatly depends on the cross-sectional shape of the structure body 160, and takes a value of n₀ < n_{eff} < n₁. Further, the effective refractive index n_{eff} of the optical waveguide also varies depending on the wavelength λ of light, and the degree of the refractive index n_{eff} greatly depends on the cross-sectional shape of the structure body 160.

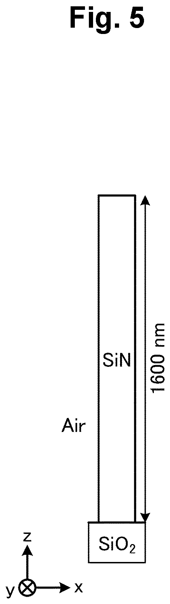

Therefore, as illustrated in Figs. 5 to 10, for example, by using the structure bodies 160 having various cross-sectional shapes such as a square shape, a cross shape, and a circular shape, it is possible to set various combinations of phase delay amounts according to the wavelength λ of light, and it is possible to newly design and achieve lenses having different condensing positions depending on the wavelength region.

### [Shape of structure body]

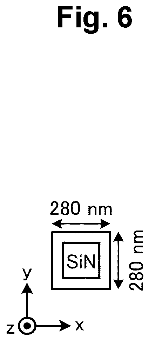

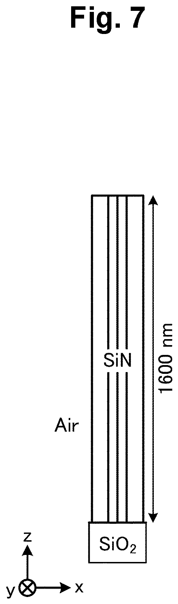

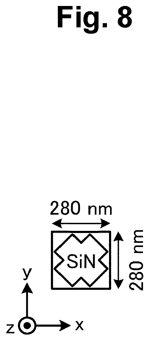

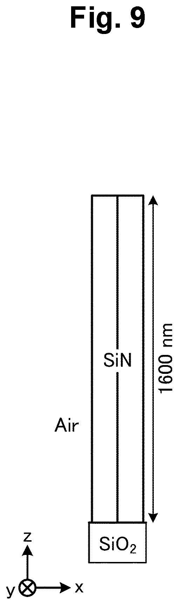

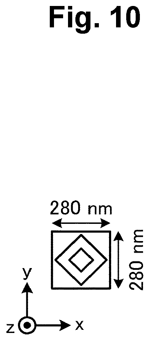

Figs. 5 to 10 are views illustrating an example of a schematic configuration of the structure body 160. Fig. 5 is a side view of the structure body 160 having a square shape in plan view. Fig. 6 is a plan view of the structure body 160 illustrated in Fig. 5. Fig. 7 is a side view of the structure body 160 having an X-shape in plan view. Fig. 8 is a plan view of the structure body 160 illustrated in Fig. 7. Fig. 9 is a side view of the structure body 160 having a hollow rhombus shape in plan view. Fig. 10 is a plan view of the structure body 160 illustrated in Fig. 9.

The structure body 160 is a columnar structure body extending in the z-axis direction, and is formed on the transparent layer 150 (for example, SiO₂ substrate (refractive index 1.45)). An example of a material of the structure body 160 is SiN (refractive index 2.05). A side and an upper side of the structure body 160 are air (Air (refractive index: 1.0)).

An arrangement period of each structure body 160 is P. The arrangement period P is desirably set as in Expression (2) so that diffracted light does not occur on the transmission side.
[Math. 2] $P ≦ {λ}_{min} / {n}_{2}$ (2)

λₘᵢₙ is the shortest wavelength in the wavelength band of the light receiving target, and is, for example, 410 nm. n₂ is a refractive index of the transparent layer 150, and in a case where the transparent layer 150 is SiO₂, n₂ = 1.45. The arrangement period P of the structure body 160 is, for example, 280 nm.

In Figs. 5 to 10, the height (length in the z-axis direction) of the structure body 160 in side view is referred to as a height h. The height h of the structure body 160 is constant. The height h is desirably set as in Expression (3) so that the structure body 160 can give an optical phase delay amount (phase value) of 2π or more to incident light, that is, light traveling along the z-axis direction.
[Math. 3] $h ≧ {λ}_{r} / \left({n}_{1}-{n}_{0}\right)$ (3)

The wavelength λᵣ is a desired center wavelength in a wavelength band on the longest wavelength side among wavelength bands of light to be subjected to wavelength separation. n₁ is a refractive index of the structure body 160. In a case where the structure body 160 is SiN, n₁ = refractive index 2.05, and the height h is, for example, 1600 nm. Further, the structure body 160 may be formed by TiO₂ (refractive index 2.40). In this case, n₁ = 2.40, and the height h of the structure body 160 is, for example, 1250 nm.

By designing (including dimensional design) the cross-sectional shape of the structure body 160, various combinations capable of giving different optical phase delay amounts to light of each wavelength can be achieved. By diversifying the cross-sectional shapes, the number of combinations is increased, and the degree of freedom in design is further improved.

For example, the structure body 160 has a square shape, a cross shape, or a circular shape in plan view. Each of the square-shaped, cross-shaped, and circular-shaped structure bodies 160 has the same basic shape and different dimensions (length, width, and the like). The shapes of the structure bodies 160 in plan view may be four-fold rotationally symmetrical shapes. Such a shape may include, for example, at least one of a square shape, a cross shape, or a circular shape. Each structure body 160 has a four-fold rotationally symmetrical shape in plan view, so that it has a characteristic independent of polarization.

As described above, it is also possible to apply a square shape, an X shape obtained by rotating a cross shape in plane by 45°, and a hollow rhombus shape as the shape of the structure body 160 in plan view. Note that, the hollow rhombus shape is an example of a shape including a square shape, and is a shape obtained by rotating the hollow square shape in plane by 45°.

Note that, when a shape rotated in plane by 45° such as an X shape or a rhombus is employed, optical coupling between adjacent structure bodies is weakened, so that optical characteristics of each structure are easily maintained without being affected by adjacent structure bodies. Consequently, an ideal phase delay amount distribution described later can be easily reproduced.

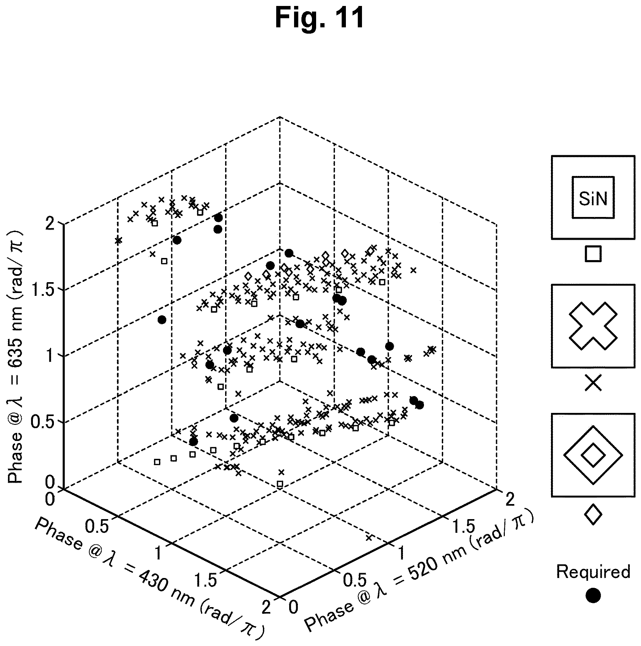

Fig. 11 is a diagram illustrating an example of combinations of wavelengths and optical phase delay amounts. As an example of blue light, an optical phase delay amount (Phase @ λ = 430 nm (rad/π)) for light having a wavelength of 430 nm is illustrated. As an example of green light, an optical phase delay amount (Phase @ λ = 520 nm (rad/π)) for light having a wavelength of 520 nm is illustrated. As an example of red light, an optical phase delay amount (Phase @ λ = 635 nm (rad/π)) for light having a wavelength of 635 nm is illustrated.

A square plot indicates an optical phase delay amount when dimensions of the cross-sectional shapes of the structure bodies 160 having square cross-sectional shapes are variously set. An X-shaped plot indicates an optical phase delay amount when dimensions of the cross-sectional shapes are variously set in the structure bodies 160 having X-shaped cross-sectional shapes. A rhombus plot illustrates an optical phase delay amount when dimensions of the cross-sectional shapes are variously set in the structure bodies 160 having hollow rhombic cross-sectional shapes. In all cases, the height h is constant. A black circle plot is an ideal optical phase delay amount in a lens design to be described later.

Fig. 11 illustrates optical phase delay amounts in a case where the structure bodies 160 are SiN. As will be appreciated, by the designs of the cross-sectional shapes of the structure bodies 160, various combinations of light of each color (light of each wavelength) and the optical phase delay amounts can be achieved. That is, optical phase delay amount characteristics (phase characteristics) having various wavelength dispersions can be achieved only by using columnar structure bodies having the same height h. This is because a wavelength dispersion characteristic of a generated optical waveguide mode or optical resonance mode and a wavelength dispersion characteristic of an optical phase delay amount caused by them can be changed depending on the cross-sectional shape.

On the basis of the above principle, a lens function having a condensing point different for each wavelength can be achieved by the designs of the cross-sectional shapes and arrangement of the structure bodies 160 arranged in the plane direction of the transparent layer 150. Note that the lens design is possible not only in a case where the number of wavelengths is three but also in a case where the number of wavelengths is two or four or more.

Furthermore, in the present embodiment, the phase distribution of the lens is designed so that light is condensed at the center of the photoelectric conversion element below the lens corresponding to the incident light of the light incident on the structure bodies 160, and the lens is designed with reference to the phase characteristics illustrated in Fig. 11. Therefore, with the cross-sectional shapes set to be different between the central portion and the outer peripheral portion of the optical element array 12, the plurality of structure bodies 160 (Figs. 3 and 4) is arranged such that, in both the central portion and the outer peripheral portion having different incident angles of incident light, light of color corresponding to the pixel B among light incident on the outside of a region facing the pixel B is also condensed on the pixel B. The light of color corresponding to the pixel G among the light incident on the outside of the region facing the pixel G is also arranged to be condensed on the pixel G. The light of color corresponding to the pixel R among the light incident on the outside of the region facing the pixel R is also arranged to be condensed on the pixel R. Thus, the amount of received light in each pixel can be increased.

### [Example of lens design]

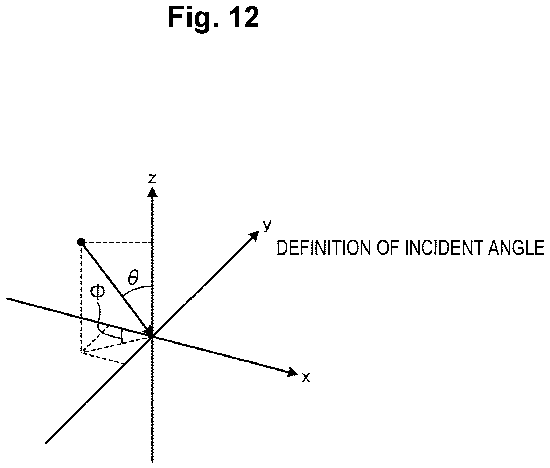

Now, an example of a lens design will be described. Fig. 12 is a view describing a definition of the incident angle. As illustrated in Fig. 12, a case where light is incident at an incident angle of (θ, φ) will be described. A phase distribution of the lens is designed so that light is condensed at the center of the photoelectric conversion element below the lens (structure bodies 160) corresponding to the incident angle (θ, φ), and the cross-sectional shapes and arrangement of the structure bodies 160 having a SiN composition structure are designed according to the ideal optical phase delay amount of the design target with reference to the phase characteristic illustrated in Fig. 11. For example, the size of the pixel is 1.68 µm × 1.68 µm. The focal length is 4.2 µm. The center wavelength corresponding to the blue light is 430 nm. The center wavelength corresponding to the green light is 520 nm. The center wavelength corresponding to the red light is 635 nm.

An optical phase delay amount distribution φ of the lens that condenses at a point (center point of any pixel) z_{f} away immediately below the lens with respect to light of a certain incident angle (θ, φ) is expressed by the following Expression (4).
[Math. 4] $φ \left(x, y\right) = - \frac{2 π}{{λ}_{d}} \left[\begin{matrix}{n}_{in} \left\{\left(x-{x}_{f}\right)cosϕ+\left(y-{y}_{f}\right)sinϕ\right\} sinθ \\ + {n}_{out} \left\{\sqrt{{\left(x-{x}_{f}\right)}^{2} + {\left(y-{y}_{f}\right)}^{2} + {z}_{f}^{2}}-\sqrt{{x}_{f}^{2} + {y}_{f}^{2} + {z}_{f}^{2}}\right\}\end{matrix}\right] + C$ (4)

In the above Expression (4), λ_{d} is a center wavelength (design wavelength). x_{f}, y_{f}, and z_{f} are condensing positions. nᵢₙ is a refractive index of a material on the incident side. nₒᵤₜ is a refractive index of a material on the emission side. C is an arbitrary constant. In a case of the configurations of Figs. 3 and 4, nᵢₙ = 1.0 (air) and nₒᵤₜ = 1.445 (quartz glass).

The ideal optical phase delay amount distribution is a phase distribution that gives the following condensing positions to each of the pixel B, the pixels G₁ and G₂, and the pixel R. Note that the center positions of the four pixels (pixel units) correspond to x = 0 and y = 0.
Pixel B: x_{f} = +0.84 µm, y_{f} = -0.84 µm, and z_{f} = 4.2 µm
Pixel G₁: x_{f} = +0.84 µm, y_{f} = +0.84 µm, and z_{f} = 4.2 µm
Pixel G₂: x_{f} = -0.84 µm, y_{f} = -0.84 µm, and z_{f} = 4.2 µm
Pixel R: x_{f} = -0.84 µm, y_{f} = +0.84 µm, and z_{f} = 4.2 µm

φ is converted so as to fall within the range of 0 to 2 π. For example, -0.5 π and 2.5 π are converted into 1.5 π and 0.5 π, respectively. A boundary region of the optical phase delay amount distribution is set so that the center of the optical phase delay amount distribution of the lens at each design wavelength is at the condensing position (together with the adjacent lens). The constant C may be optimized so that the error (difference from the ideal value) of the optical phase delay amount distribution is minimized at each wavelength. From the optical phase delay amount at each wavelength, a structure most suitable for the optical phase delay amount distribution at each of the center wavelengths of the three wavelengths (structure with the smallest error) is arranged at a corresponding position.

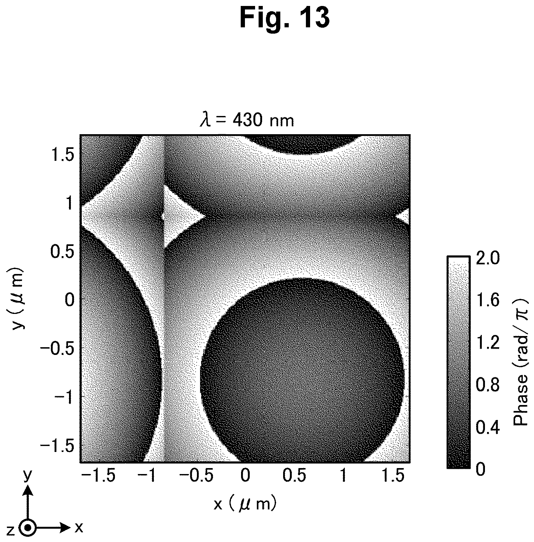

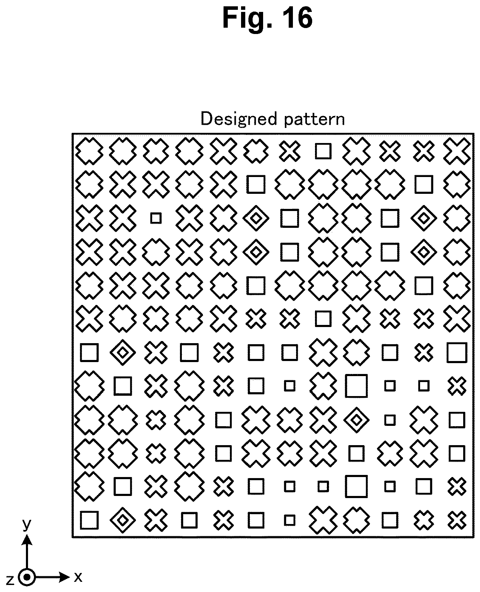

Figs. 13 to 16 are diagrams illustrating examples of lens designs in a case where the structure bodies 160 are SiN. Figs. 13 to 16 illustrate examples of lens designs in a case where light is incident at an incident angle of θ = 5° and φ = 0°. As illustrated in Fig. 16, a plurality of structure bodies 160 is formed in the shapes and arrangement for condensing light having wavelengths respectively corresponding to the pixels R, G₁, G₂, and B. Note that the center position in Fig. 16 corresponds to x = 0 and y = 0.

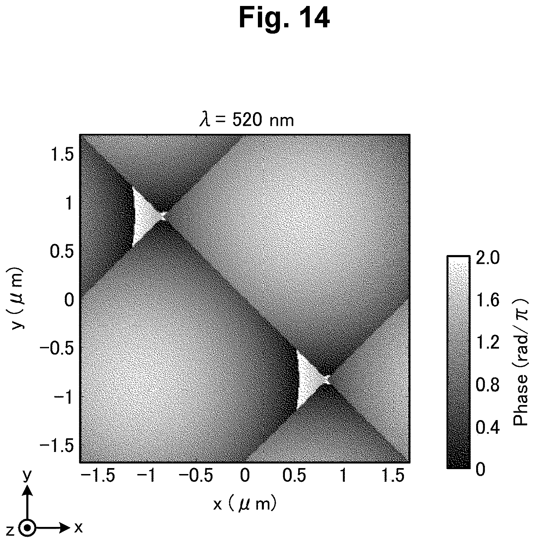

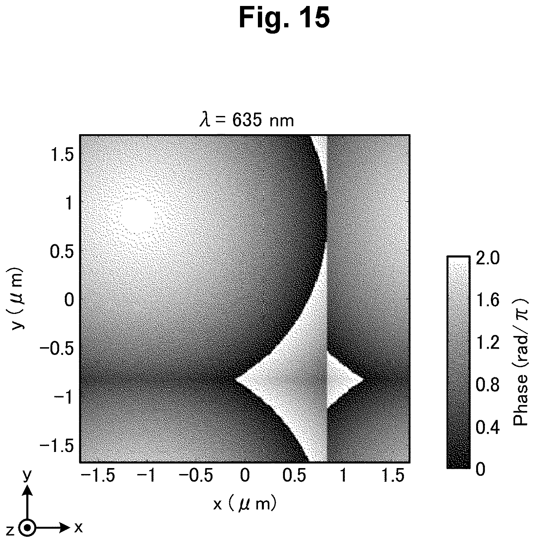

Fig. 13 illustrates an ideal optical phase delay amount distribution (Phase (rad/π)) in a case where the center wavelength is 430 nm (blue light). Fig. 14 illustrates an ideal optical phase delay amount distribution in a case where the center wavelength is 520 nm (green light). Fig. 15 illustrates an ideal optical phase delay amount distribution in a case where the center wavelength is 635 nm (red light).

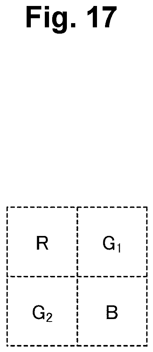

Fig. 16 is a plan view of the structure bodies 160 capable of achieving the optical phase delay amount distribution in each of Figs. 13 to 15, and is a shape pattern of the structure bodies 160 designed per pixel unit (see Fig. 17 described later).

As illustrated in Fig. 16, shapes of the structure bodies 160 are square-shaped, ×-shaped, and hollow rhombic prisms. The planar shape of the structure body 160 is set to a shape that can achieve phases at corresponding positions in the optical phase delay amount distributions illustrated in Figs. 13 to 15 in a case where light is incident at an incident angle of θ = 5° and φ = 0°. For this reason, the planar shapes of the structure bodies 160 may be set to one type (for example, a square shape) instead of a plurality of types of shapes such as a square shape, a × shape, and a hollow rhombus. Further, the shapes of the structure bodies 160 are not limited to wavelength regions to be separated, and any one of a square shape, a × shape, and a hollow rhombus can be set. Note that the types of the planar shapes of the structure bodies 160 may be set for each wavelength region to be separated.

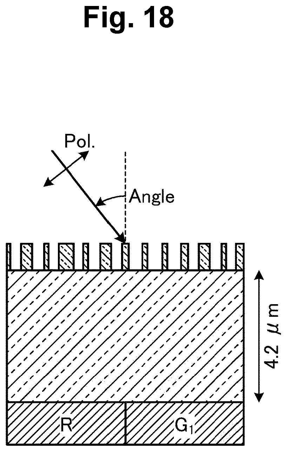

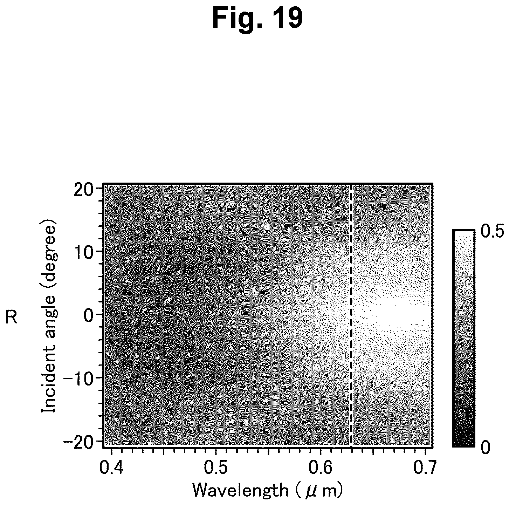

Fig. 17 is a view schematically illustrating a pixel arrangement of a pixel unit in the pixel array 110. It is a diagram illustrating an example of an arrangement. Fig. 18 is a view describing the definition of the incident angle. Figs. 19 to 30 are diagrams illustrating examples of incident angle dependency of received light intensity in a pixel. Figs. 17 to 30 illustrate examples of the incident angle dependency in a case where the structure bodies 160 are SiN. In this case, the shapes of the structure bodies 160 are obtained by changing the pattern according to a main incident angle, that is, according to the pixel position in the sensor (imaging element 100).

As described above, a plurality of pixel units including the pixel R, the pixel G₁, the pixel G₂, and the pixel B is arranged in the pixel array 110 as illustrated in Fig. 17. At this time, as illustrated in Fig. 18, the incident angle dependency of the light reception spectra of the pixel R, the pixel G₁, the pixel G₂, and the pixel B in a case where an angle (Angle) on the xz plane with the z-axis direction set to 0° is an incident angle is illustrated in Figs. 19 to 26.

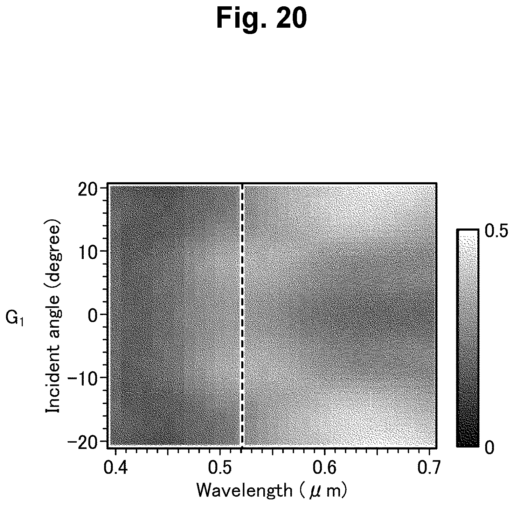

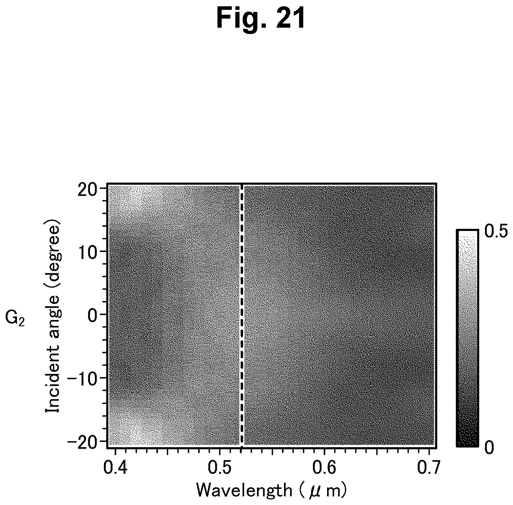

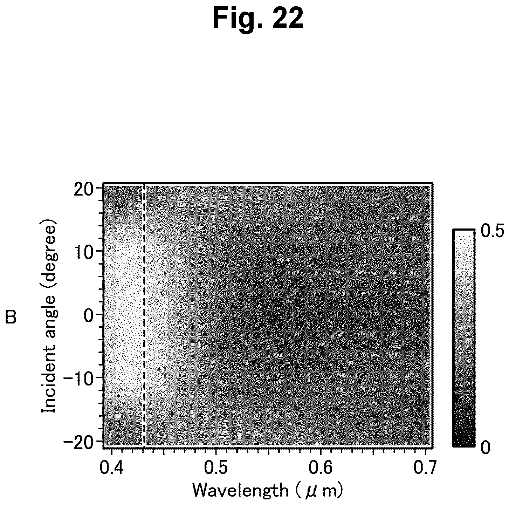

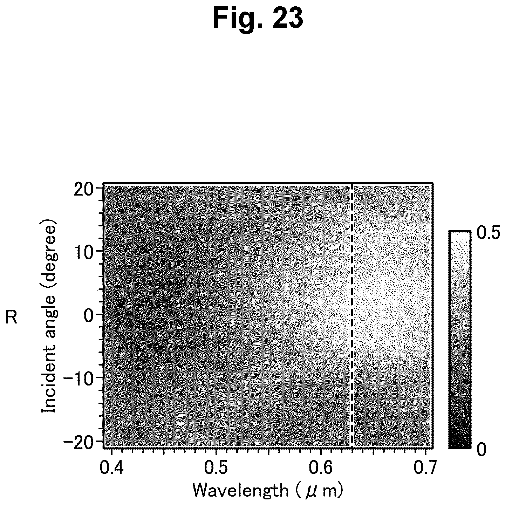

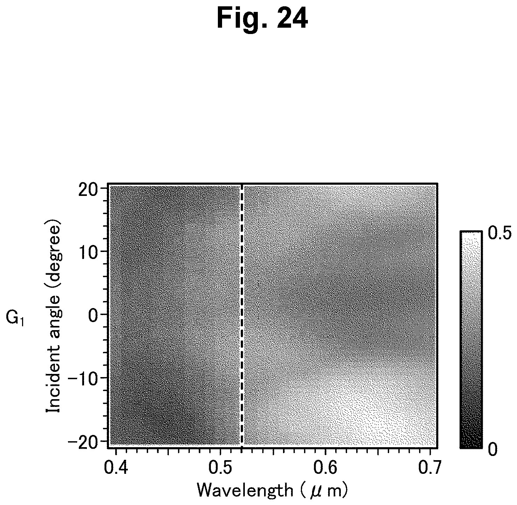

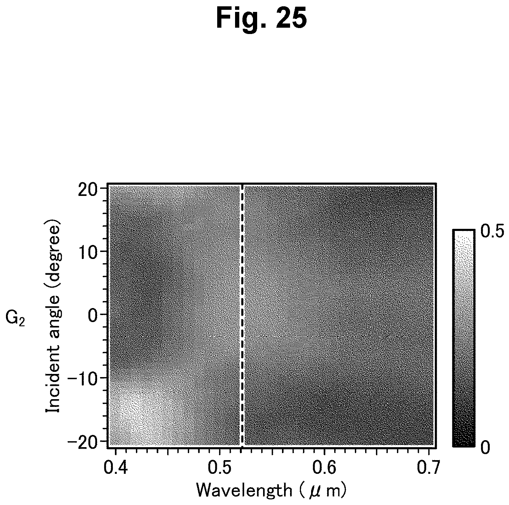

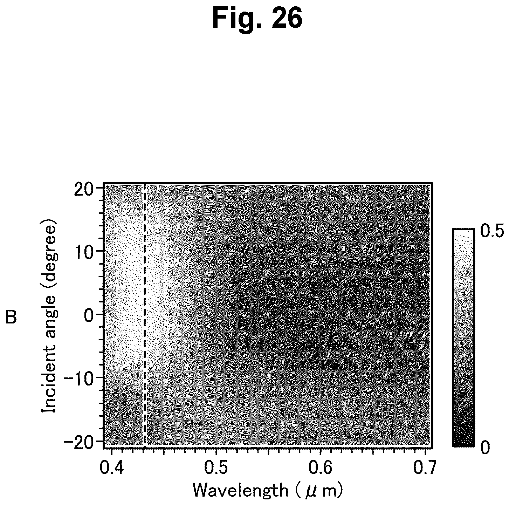

Figs. 19 to 22 illustrate a case where the lens is optimally designed with respect to a case where light is incident at an incident angle of θ = 0° and φ = 0°. Figs. 23 to 26 illustrate a case where the lens is optimally designed with respect to a case where light is incident at an incident angle of θ = 5° and φ = 0°. In Figs. 19 and 23, the light receiving efficiency of the pixel R is indicated by received light intensity for each wavelength (Wavelength (µm)) and for each incident angle (Incident angle (degree)), that is, for each incident angle. In Figs. 20 and 24, the light receiving efficiency of the pixel G₁ is indicated by received light intensity for each incident angle. In Figs. 21 and 25, the light receiving efficiency of the pixel G₂ is indicated by received light intensity for each incident angle. In Figs. 22 and 26, the light receiving efficiency of the pixel B is indicated by received light intensity for each incident angle. For both incident angles of θ = 0° and θ = 5°, light can be received with sufficient intensity in a range where the incident angle is approximately ±12° at the center wavelength in the pixel R, the pixel G₁, the pixel G₂, and the pixel B.

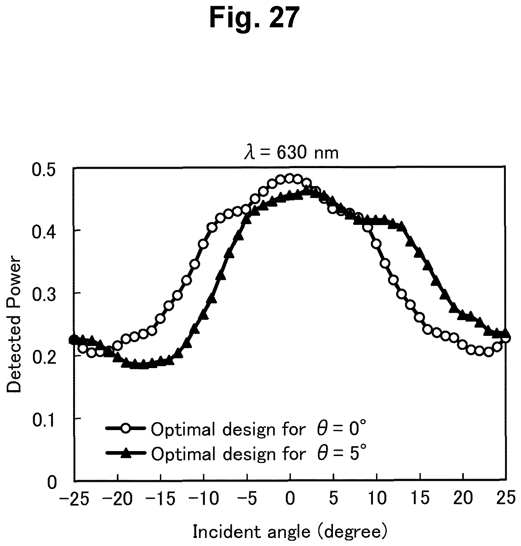

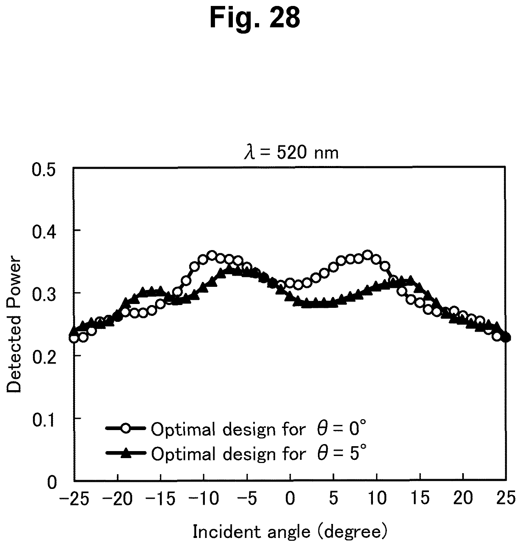

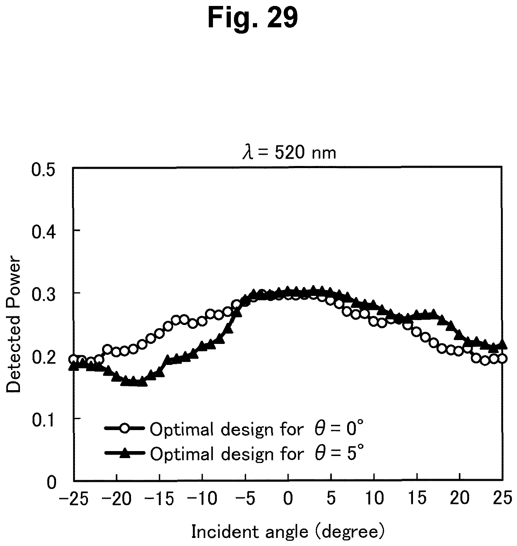

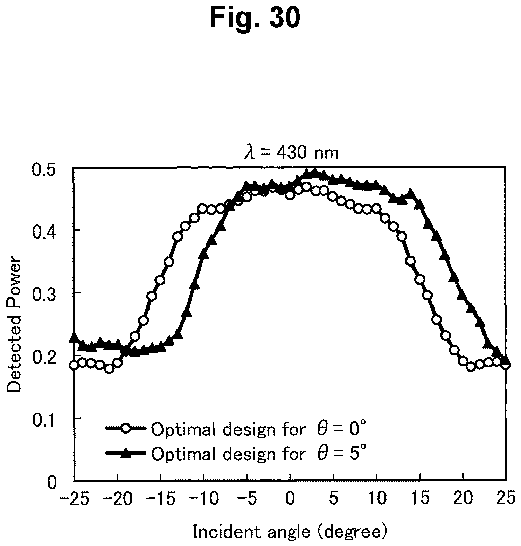

Further, Figs. 27 to 30 are diagrams illustrating the incident angle dependency of detection intensity of the light having the center wavelength received by each pixel, and each illustrate a case where θ = 0° and θ = 5°. Fig. 27 illustrates detection intensity of light having a wavelength of 630 nm by the pixel R, Fig. 28 illustrates detection intensity of light having a wavelength of 520 nm by the pixel G₁, Fig. 29 illustrates detection intensity of light having a wavelength of 520 nm by the pixel G₂, and Fig. 30 illustrates detection intensity of light having a wavelength of 430 nm by the pixel B.

As illustrated in Figs. 27 to 30, in a case where the lens is optimally designed at the incident angle θ = 5°, the range of incident angle resistance is shifted by +5° in all the pixels as compared with a case where the lens is optimally designed at the incident angle θ = 0°.

### [Effects of first embodiment]

As described above, in the first embodiment, in the imaging element 100, since the optical element array 120 achieves both the color separation function and the lens function, the total amount of received light can also be increased as compared with a conventional imaging element that performs color separation using a color filter.

Then, in the imaging element 100, angle resistance corresponding to the main incident angle is imparted to the lens (structure bodies 160) of the optical element array 120 while having a color separation function. According to the first embodiment, by changing the pattern of the structure bodies 160 according to the pixel position in the imaging element 100, it is possible to achieve color separation microlenses respectively corresponding to different main incident angles at the central portion and the peripheral portion of the imaging element 100. Therefore, according to the first embodiment, it is possible to achieve a light condensing function corresponding to various incident angles determined at positions in the imaging element 100 for each pixel, and in particular, it is possible to improve the light receiving sensitivity in the peripheral portion of the imaging element 100. Therefore, according to the first embodiment, it is possible to generate an image signal having uniform luminance over the entire imaging element 100 and few color errors.

In addition, some conventional technologies have a microlens provided (integrated) on the side opposite to the pixel across the filter in order to increase the amount of received light (improve sensitivity) by improving an aperture ratio, reducing light incident angle dependency, and the like. In this case, since a two-layer structure of at least a filter and a microlens is formed, the structure becomes complicated and the manufacturing cost also increases. With the optical element array 120 according to the embodiment, since the wavelength separation function and the lens function can be achieved only by the optical element array 120, the structure can be simplified and the manufacturing cost can be reduced. Further, since the plurality of structure bodies 160 can be arranged without gaps within a plane (in the xy plane), the aperture ratio increases as compared with the microlens.

Note that, since resistance to the incident angle mainly depends on a focal length of a color separation lens, if a lens (structure bodies 160) having a shorter focal length is designed, the allowable angle also increases.

Further, the signal processing unit 13 illustrated in Fig. 1 generates a pixel signal on the basis of an electric signal obtained from the imaging element 12. In order to obtain the electric signal, the signal processing unit 13 also controls the imaging element 12. The control of the imaging element 12 includes exposure of pixels of the imaging element 12, conversion of charges accumulated in the pixel array 110 into electric signals, reading of the electric signals, and the like.

Further, the optical element array 120 is not limited to the above configuration, and can take various forms in the number, interval, structural shape, and arrangement pattern of the structure bodies 160. In addition, the structure bodies 160 may be connected to each other or may be embedded in a transparent material.

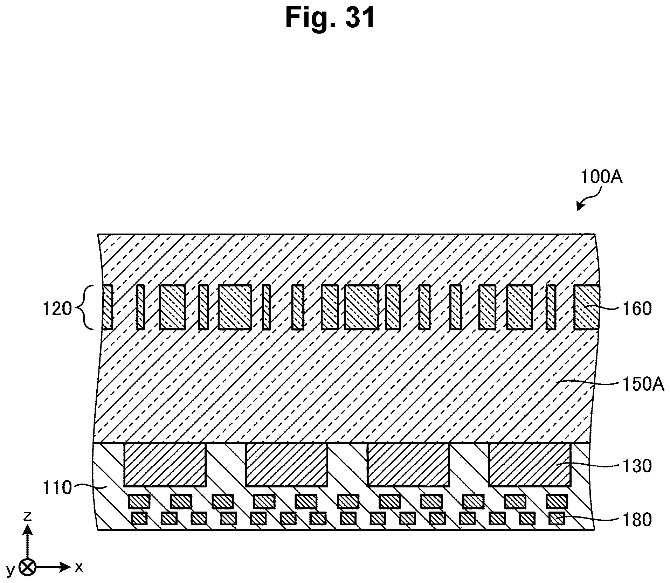

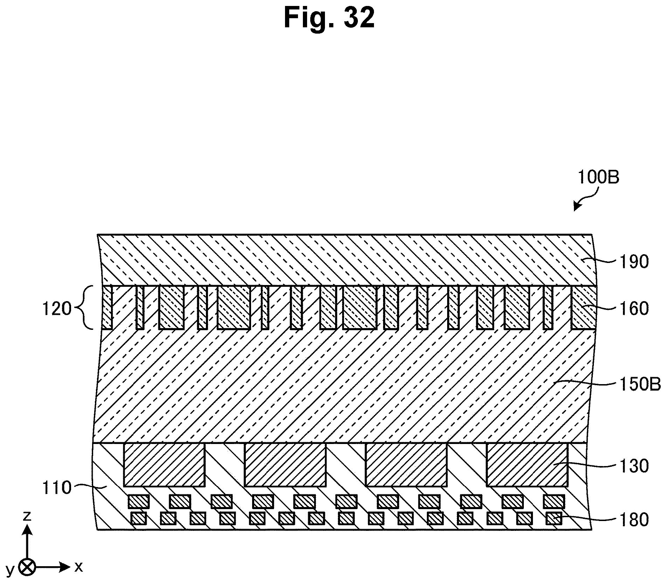

Further, in Figs. 3 and 4, the optical element array 120 is formed on the upper surface of the transparent layer 150, but the present invention is not limited thereto. Figs. 31 and 32 are views schematically illustrating another example of a part of the cross sections of the pixel array and the optical element array in the imaging element according to the first embodiment.

As illustrated in an imaging element 100A of Fig. 31, the optical element array 120 may be embedded inside a transparent layer 150A on the pixel 130. At this time, the material of the transparent layer 150A may be a single material or a plurality of layered materials. In addition, as illustrated in the imaging element 100B of Fig. 32, the optical element array 120 may be formed on a bottom surface of an independent transparent substrate 190. In this case, the region between the optical element array 120 and the pixel 130 is filled with air 150B. At this time, the material of the transparent substrate 190 may be a single material or a plurality of layered materials. The imaging elements 100, 100A, and 100B can be used in combination with an on-chip microlens, an internal microlens, an inter-pixel barrier for reducing crosstalk, and the like.

Further, in the above description, an example in which four pixels are located immediately below one optical element unit has been described, but the present invention is not limited thereto.

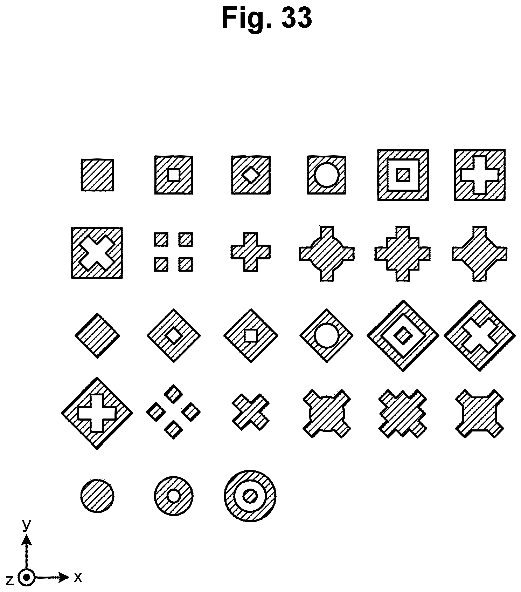

Further, the cross-sectional shapes of the structure bodies 160 are not limited to the shape illustrated in Fig. 16 and the like described above. Fig. 33 is a view illustrating an example of the cross-sectional shapes of the structure bodies. The structure bodies 160 may have various cross-sectional shapes as exemplified in Fig. 33. Exemplary shapes are, for example, four-fold rotationally symmetrical shapes obtained by variously combining square, cross, and circular shapes.

### [Second embodiment]

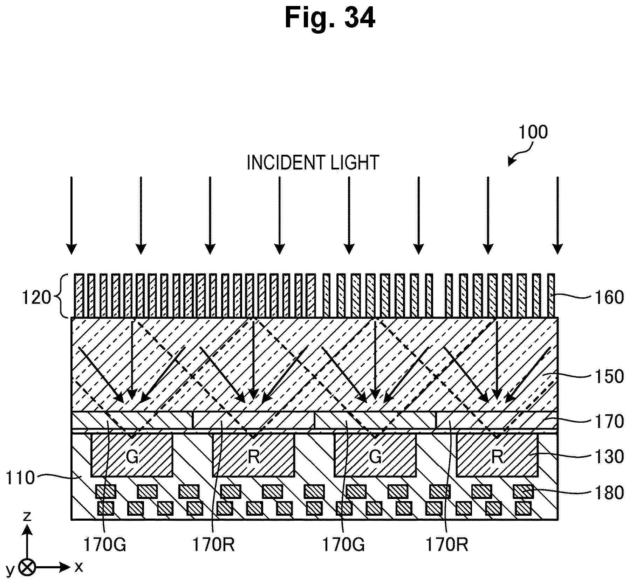

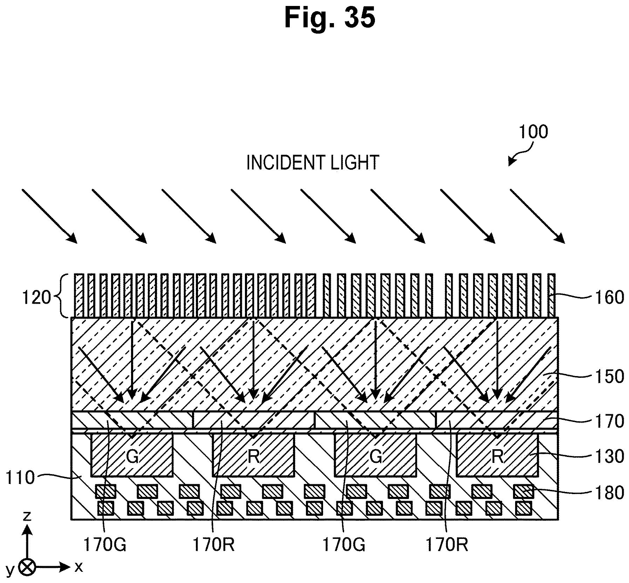

In a second embodiment, a configuration in which an imaging element includes a filter will be described. Fig. 34 is a view schematically illustrating a part of cross sections of a pixel array and an optical element array in a central portion of the imaging element according to the second embodiment. Fig. 35 is a view schematically illustrating a part of cross sections of the pixel array and the optical element array in an outer peripheral portion of the imaging element according to the second embodiment.

The imaging element 200 illustrated in Figs. 34 and 35 includes a filter layer 170 provided between the pixel array 110 and the optical element array 120.

The filter layer 170 includes a filter 170R that is provided so as to cover the pixels R and transmits red light, a filter 170G that is provided so as to cover the pixels G and transmits green light, and a filter 170B that is provided so as to cover the pixels B and transmits blue light. An example of the material of the filter layer 170 is an organic material such as resin.

The light color-separated by the optical element array 120 further passes through the filter layer 170 and then reaches the pixel array 110. By the wavelength separation of both the optical element array 120 and the filter layer 170, the crosstalk of the spectrum is suppressed (most of unnecessary other wavelength components are removed) and color reproducibility is improved as compared with a case where the wavelength separation is performed only on one side. Further, since the incident light passes through the filter layer 170 after being separated by the optical element array 120, the amount of light is not greatly reduced. Therefore, the light receiving efficiency of the pixel is improved as compared with a case where the optical element array 120 is not provided and only the filter layer 170 is provided.

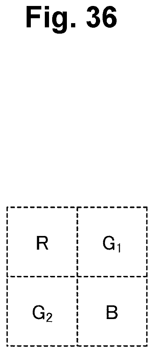

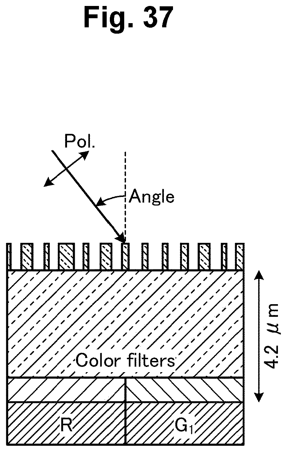

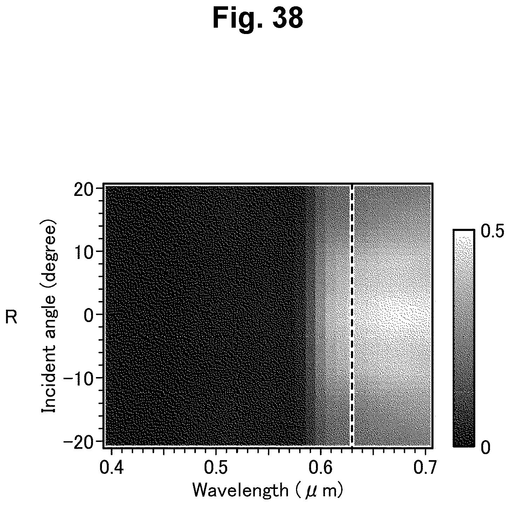

Fig. 36 is a view schematically illustrating a pixel arrangement of pixel units in the pixel array 110. Fig. 37 is a view describing the definition of the incident angle. Figs. 38 to 45 are diagrams illustrating examples of incident angle dependency of received light intensity in a pixel. Figs. 38 to 45 illustrate examples of the incident angle dependency in a case where the structure bodies 160 are SiN.

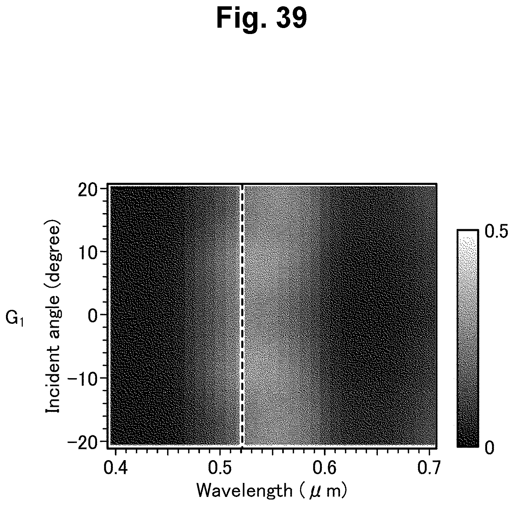

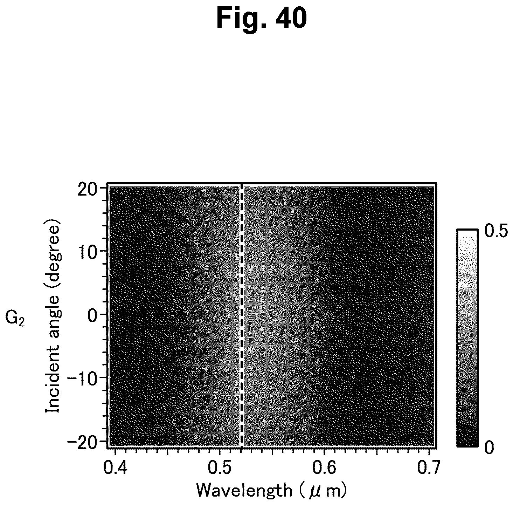

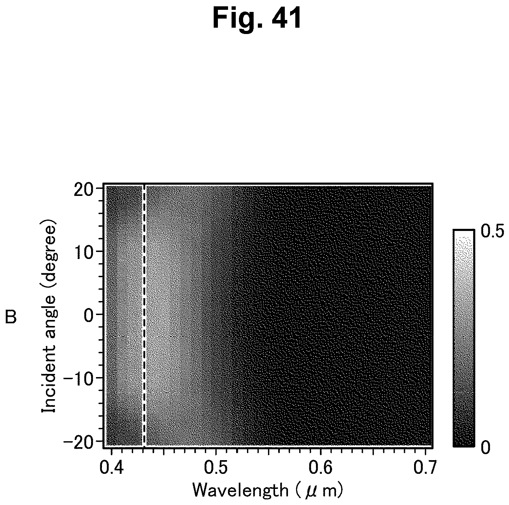

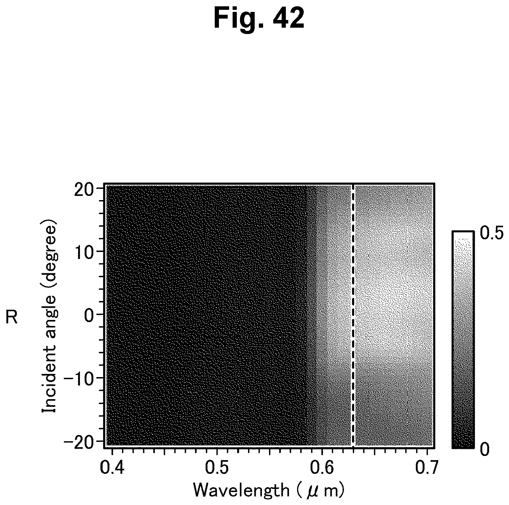

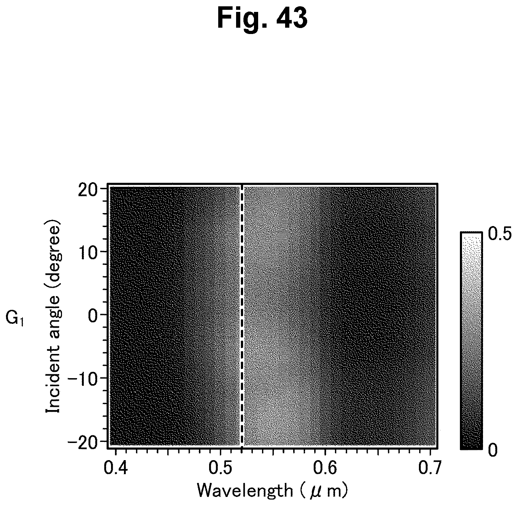

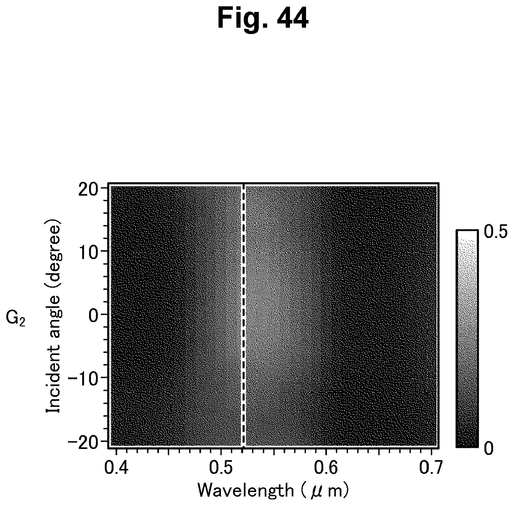

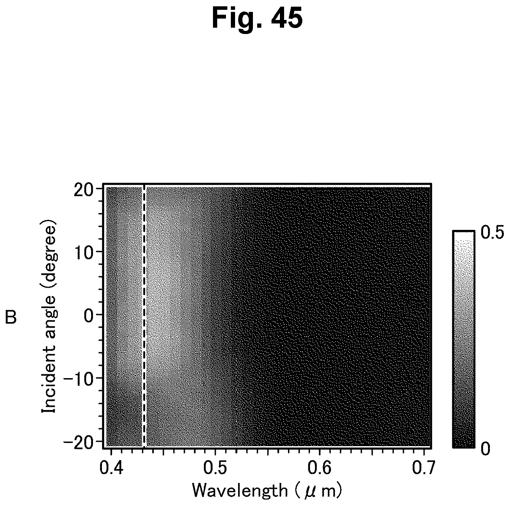

Figs. 38 to 41 illustrate a case where the lens is optimally designed with respect to a case where light is incident at an incident angle of θ = 0° and φ = 0°. Figs. 42 to 45 illustrate a case where the lens is optimally designed with respect to a case where light is incident at an incident angle of θ = 5° and φ = 0°. In Figs. 38 and 42, the light receiving efficiency of the pixel R is indicated by the received light intensity for each wavelength and for each incident angle, that is, for each incident angle. In Figs. 39 and 43, the light receiving efficiency of the pixel G₁ is indicated by the received light intensity for each incident angle. In Figs. 40 and 44, the light receiving efficiency of the pixel G₂ is indicated by the received light intensity for each incident angle. In Figs. 41 and 45, the light receiving efficiency of the pixel B is indicated by the received light intensity for each incident angle.

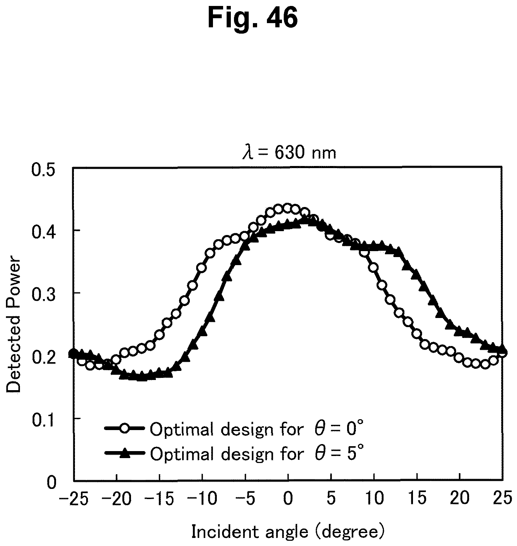

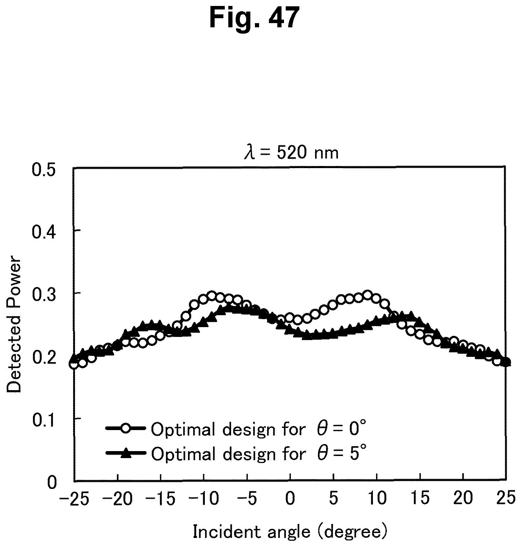

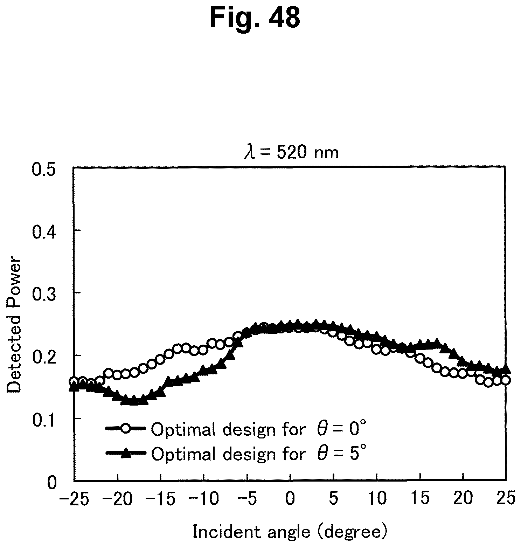

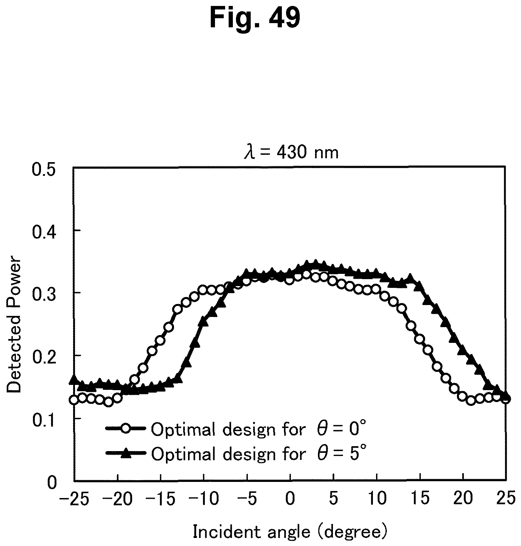

Figs. 46 to 49 are diagrams illustrating the incident angle dependency of detection intensity of the light having the center wavelength received by each pixel, and each illustrate a case where θ = 0° and θ = 5°. Fig. 46 illustrates detection intensity of light having a wavelength of 630 nm by the pixel R, Fig. 47 illustrates detection intensity of light having a wavelength of 520 nm by the pixel G₁, Fig. 48 illustrates detection intensity of light having a wavelength of 520 nm by the pixel G₂, and Fig. 49 illustrates detection intensity of light having a wavelength of 430 nm by the pixel B.

As illustrated in Figs. 38 to 45, it can be seen that most of unnecessary other wavelength components are removed at both incident angles of θ = 0° and θ = 5°, and the color reproducibility is improved. Note that, regarding the transmission characteristics of the filter layer 170, refer to Fig. 20 of Reference Document 1, for example.

Reference Document 1: Kudo, T.; Nanjo, Y.; et al., "Pigmented Photoresists for Color Filters". J. Photopolym. Sci. Technol. 1996, 9, 109-120.

Further, as illustrated in Figs. 46 to 49, in a case where the lens is optimally designed at the incident angle θ = 5°, the range of incident angle resistance is shifted by +5° in all the pixels as compared with a case where the lens is optimally designed at the incident angle θ = 0°.

### [Effects of second embodiment]

As described above, with the imaging element 200 further including the filter layer 170, the light receiving efficiency can be improved, and the color reproducibility can be further improved.

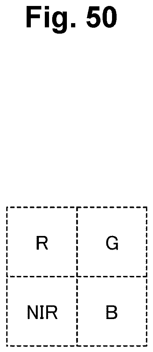

Note that, in the first and second embodiments, when the pixel arrangement of the pixel array 110 is described, the pixel unit in which the pixel B, the pixels G₁ and G₂, and the pixel R are one set has been described as an example, but the present invention is not limited thereto. Fig. 50 is a view schematically illustrating another pixel arrangement of the pixel unit in the pixel array. As illustrated in Fig. 50, the pixel array may have a pixel arrangement including a pixel NIR (near-infrared) that receives near-infrared (NIR) light, instead of the pixel G₂ illustrated in Fig. 17. At this time, the lens (structure body 160) corresponding to the pixel NIR may be designed using Expression (4) with the center wavelength λ_{d} set to, for example, 850 nm.

Further, in the first and second embodiments, SiN or TiO₂ has been described as an example of the material of the structure body 160. However, the material of the structure bodies 160 is not limited thereto. For example, for light having a wavelength of 380 nm to 1000 nm (visible light to near-infrared light), SiC, TiO₂, GaN, or the like may be used as the material of the structure bodies 6 in addition to SiN. This is suitable because the refractive index is high and the absorption loss is small. In the case of using light having a wavelength of 800 to 1000 nm (near-infrared light), Si, SiC, SiN, TiO₂, GaAs, GaN, or the like may be used as the material of the structure bodies 6. It is suitable because of its low loss.
For light in a near-infrared region in a long wavelength band (such as 1.3 µm or 1.55 µm as a communication wavelength), InP or the like can be used as the material of the structure bodies 160 in addition to the above-described materials.

Further, in a case where the structure bodies 160 are formed by bonding, coating, or the like, polyimide such as fluorinated polyimide, BCB (benzocyclobutene), a photocurable resin, a UV epoxy resin, an acrylic resin such as PMMA, and polymers such as resists in general may be mentioned as materials.

Further, in the first and second embodiments, the example in which SiO₂ and an air layer are assumed as the material of the transparent layer 150 has been described, but the material is not limited thereto. Any material may be used as long as it has a refractive index lower than the refractive index of the material of the structure bodies 160 and has a low loss with respect to the wavelength of incident light, including a general glass material and the like. The transparent layer 150 only needs to have a sufficiently low loss with respect to the wavelength of light to reach the corresponding pixel, and thus may include a material similar to that of the color filter, and may include an organic material such as resin, for example. In this case, the transparent layer 150 may not only include a material similar to that of the color filter, but may also have a structure similar to that of the color filter and may be designed to have absorption characteristics according to the wavelength of light to be guided to the corresponding pixel.

In addition, in the first and second embodiments, the three primary colors of RGB and the near-infrared light have been described as examples of the corresponding color of the pixel, but the pixel may also correspond to light of wavelengths other than the near-infrared light and the three primary colors (for example, infrared light, ultraviolet light, and the like).

Further, in the first and second embodiments, the example has been described in which the structure bodies having three different cross-sectional shapes of a square shape, a × shape, and a hollow rhombus is used as the shapes of the structure bodies 160. This shape is an example, and two types of structure bodies (for example, only a square shape or a cross shape is used) may be used, or four or more types of structure bodies may be used.

Although the present invention has been described above on the basis of specific embodiments, the present invention is not limited to the above-described embodiments, and it goes without saying that various modifications can be made without departing from the gist of the present invention.

The technology described above is specified as follows, for example. As described with reference to Figs. 1 to 5, 31, 32, and the like, the optical element array 120 includes the transparent layer 150 for covering a plurality of pixels each including a photoelectric conversion element, and the plurality of structure bodies 160 arranged on the transparent layer 150 or in the transparent layer 150 in a plane direction (xy plane direction) of the transparent layer 150, in which the plurality of structure bodies 160 is arranged in such a manner that, among incident light, light of a first color (for example, blue) is condensed on a first pixel (for example, the pixel B) located immediately below and light of a second color (for example, red) is condensed on a second pixel (for example, the pixel R) located immediately below according to an incident angle of incident light of each of the structure bodies.

The optical element array 120 has angle resistance corresponding to the main incident angle while having a color separation function. The optical element array 120 can achieve a light condensing function corresponding to various incident angles determined at positions in the imaging element 100 for each pixel, and can improve light receiving sensitivity particularly in a sensor peripheral portion. In the optical element array 120, since the plurality of structure bodies 160 can be arranged without gaps within a plane, the aperture ratio also increases as compared with the microlens. The color separation function and the lens function may correspond to three colors, and may further correspond to separation of near-infrared light.

As described with reference to Figs. 5 to 10 and the like, each of the plurality of structure bodies 160 may be a columnar structure body having a refractive index higher than a refractive index of the transparent layer 5 and giving an optical phase delay amount according to a cross-sectional shape to the incident light. Then, a cross-sectional shape of each of the plurality of structure bodies is different between a central portion and an outer peripheral portion of the optical element. As described with reference to Figs. 11 to 16 and the like, the plurality of structure bodies 160 may be arranged according to the optical phase delay amount distribution for achieving the above-described light condensation. For example, both functions of the wavelength separation function and the lens function can be achieved by the arrangement of the plurality of structure bodies 160.

As described with reference to Figs. 16 and 33, and the like, a cross-sectional shape of each of the plurality of structure bodies 160 may be a four-fold rotationally symmetrical shape. Thus, polarization dependency can be prevented from occurring.

As described with reference to Figs. 6 to 8 and the like, the plurality of structure bodies 160 may be arranged in such a manner that light of a color corresponding to one pixel among light incident on an outside of a region facing the one pixel is also condensed on the one pixel. Thus, the amount of received light can be increased as compared with a case where only light incident on the region facing the one pixel is condensed on the pixel.

The imaging element 100 described with reference to Figs. 1 to 5 and the like is also one aspect of the present disclosure. The imaging element 100 includes an optical element array 120 and a plurality of pixels 130 (pixels NIR and the like) covered with a transparent layer 150. Thus, as described above, the manufacturing cost can be reduced. The light receiving sensitivity can be improved or the aperture ratio can be increased.

As described with reference to Figs. 34 and 35, and the like, the imaging element 200 may include the filter layer 170 provided between a plurality of pixels (pixels NIR and the like) and the transparent layer 150. Thus, the light receiving efficiency can be improved, and the color reproducibility can be further improved.

The imaging device 10 described with reference to Fig. 1 and the like is also one aspect of the present disclosure. The imaging device 10 includes the above-described imaging element 12 and a signal processing unit 13 that generates an image signal on the basis of a pixel signal on the basis of an electric signal obtained from the imaging element 12. Thus, as described above, the manufacturing cost can be reduced. The light receiving sensitivity can be improved or the aperture ratio can be increased.

### Reference Signs List

- 1: Object
- 10: Imaging device
- 11: Lens optical system
- 12, 100, 100A, 100B, 200: Imaging element
- 13: Signal processing unit
- 110: Pixel array
- 120: Optical element array
- 130: Pixel
- 150, 150A: Transparent layer
- 160: Structure body
- 170: Filter layer
- 180: Wiring layer
- 190: Transparent substrate

## Claims

1. An imaging element (120), comprising:
a transparent layer (150) for covering a plurality of pixels each including a photoelectric conversion element; and
a plurality of structure (160) bodies arranged on the transparent layer (150) or in the transparent layer (150) in a plane direction of the transparent layer (150), each of the plurality of structure (160) bodies is a columnar structure body having a refractive index higher than a refractive index of the transparent layer (150) and giving an optical phase delay amount according to a cross-sectional shape to the incident light, and
the plurality of pixels (130) covered with the transparent layer (150), wherein
a cross-sectional shape of the plurality of structure (160) bodies is set according to an optical phase delay amount distribution for achieving the light condensation, and the plurality of structure (160) bodies is arranged according to the optical phase delay amount distribution for achieving the light condensation, wherein a cross-sectional shape of each of the structure bodies (160) is different between the central portion and the outer peripheral portion of the imaging element, and
the plurality of structure (160) bodies is arranged in such a manner that, among incident light, light of a first color is condensed on a first pixel located immediately below at a first condensing position, and light of a second color is condensed on a second pixel located immediately below at a second condensing position different from the first condensing position, according to an incident angle of incident light of each of the structure (160) bodies.

2. The imaging element according to claim 1, wherein a cross-sectional shape of each of the plurality of structure (160) bodies is different between a central portion and an outer peripheral portion of the imaging element.

3. The imaging element according to any one of claims 1 to 2, wherein a cross-sectional shape of each of the plurality of structure (160) bodies is a four-fold rotationally symmetrical shape.

4. The imaging element according to any one of claims 1 to 3, wherein the plurality of structure (160) bodies is arranged in such a manner that light of a color corresponding to one pixel among light incident on an outside of a region facing the one pixel is also condensed on the one pixel.

5. The imaging element (12) according to any one of claims 1 - 4, further comprising a filter layer provided between the plurality of pixels and the transparent layer (150).

6. An imaging device (10), comprising:
the imaging element (12) according to any one of claims 1 to 5; and
a signal processing unit (13) that generates an image signal on a basis of an electric signal obtained from the imaging element (12).

## Patentansprüche

1. Bildgebungselement (120), umfassend:
eine transparente Schicht (150) zum Bedecken einer Vielzahl von Pixeln, die jeweils ein photoelektrisches Umwandlungselement einschließen; und
eine Vielzahl von auf der transparenten Schicht (150) oder in der transparenten Schicht (150) in einer Ebenenrichtung der transparenten Schicht (150) angeordneten Strukturkörpern (160), wobei jeder der Vielzahl von Strukturkörpern (160) ein säulenförmiger Strukturkörper ist, der einen Brechungsindex aufweist, der höher als ein Brechungsindex der transparenten Schicht (150) ist, und dem einfallenden Licht nach einer Querschnittsform einen optischen Phasenverzögerungsbetrag verleiht, und
die Vielzahl von mit der transparenten Schicht (150) bedeckten Pixeln (130), wobei
eine Querschnittsform der Vielzahl von Strukturkörpern (160) nach einer Verteilung des optischen Phasenverzögerungsbetrags zum Erreichen der Lichtbündelung festgelegt ist, und die Vielzahl von Strukturkörpern (160) nach der Verteilung des optischen Phasenverzögerungsbetrags zum Erreichen der Lichtbündelung angeordnet ist, wobei eine Querschnittsform jedes der Strukturkörper (160) zwischen dem zentralen Bereich und dem äußeren Umfangsbereich des Bildgebungselements unterschiedlich ist, und
die Vielzahl von Strukturkörpern (160) nach einem Einfallswinkel des auf jeden der Strukturkörper (160) einfallenden Lichts derart angeordnet ist, dass unter einfallendem Licht Licht einer ersten Farbe auf einem unmittelbar darunter angeordneten ersten Pixel an einer ersten Bündelungsposition gebündelt wird, und Licht einer zweiten Farbe auf einem unmittelbar darunter angeordneten zweiten Pixel an einer zweiten Bündelungsposition, die sich von der ersten Bündelungsposition unterscheidet, gebündelt wird.

2. Bildgebungselement nach Anspruch 1, wobei eine Querschnittsform jedes der Vielzahl von Strukturkörpern (160) zwischen einem zentralen Bereich und einem äußeren Umfangsbereich des Bildgebungselements unterschiedlich ist.

3. Bildgebungselement nach einem der Ansprüche 1 bis 2, wobei eine Querschnittsform jedes der Vielzahl von Strukturkörpern (160) eine vierfach rotationssymmetrische Form ist.

4. Bildgebungselement nach einem der Ansprüche 1 bis 3, wobei die Vielzahl von Strukturkörpern (160) derart angeordnet ist, dass Licht einer einem Pixel entsprechenden Farbe unter Licht, das außerhalb eines dem einen Pixel gegenüberliegenden Bereichs einfällt, ebenfalls auf dem einen Pixel gebündelt wird.

5. Bildgebungselement (12) nach einem der Ansprüche 1-4, weiter eine Filterschicht umfassend, die zwischen der Vielzahl von Pixeln und der transparenten Schicht (150) vorgesehen ist.

6. Bildgebungsvorrichtung (10), umfassend:
das Bildgebungselement (12) nach einem der Ansprüche 1 bis 5; und
eine Signalverarbeitungseinheit (13), die auf der Grundlage eines elektrischen Signals, das von dem Bildgebungselement (12) erhalten wird, ein Bildsignal erzeugt.

## Revendications

1. Élément d'imagerie (120), comprenant :
une couche transparente (150) pour recouvrir une pluralité de pixels incluant chacun un élément de conversion photoélectrique ; et
une pluralité de corps de structure (160) disposés sur la couche transparente (150) ou dans la couche transparente (150) dans une direction planaire de la couche transparente (150), chacun de la pluralité des corps de structure (160) est un corps de structure colonnaire présentant un indice de réfraction supérieur à un indice de réfraction de la couche transparente (150) et donnant une quantité de retard de phase optique selon une forme en coupe transversale à la lumière incidente, et
la pluralité de pixels (130) recouverte de la couche transparente (150), dans lequel
une forme en coupe transversale de la pluralité de corps de structure (160) est définie selon une distribution de quantité de retard de phase optique pour réaliser la condensation de la lumière, et la pluralité de corps de structure (160) est disposée selon la distribution de quantité de retard de phase optique pour réaliser la condensation de la lumière, dans lequel une forme en coupe transversale de chacun des corps de structure (160) est différente entre la portion centrale et la portion périphérique externe de l'élément d'imagerie, et
la pluralité de corps de structure (160) est disposée de telle manière que, parmi la lumière incidente, de la lumière d'une première couleur est condensée sur un premier pixel situé immédiatement au-dessous à une première position de condensation, et de la lumière d'une deuxième couleur est condensée sur un deuxième pixel situé immédiatement au-dessous à une deuxième position de condensation différente de la première position de condensation, selon un angle d'incidence de la lumière incidente de chacun des corps de structure (160).

2. Élément d'imagerie selon la revendication 1, dans lequel une forme en coupe transversale de chacun de la pluralité de corps de structure (160) est différente entre une portion centrale et une portion périphérique externe de l'élément d'imagerie.

3. Élément d'imagerie selon l'une quelconque des revendications 1 à 2, dans lequel une forme en coupe transversale de chacun de la pluralité de corps de structure (160) est une forme à symétrie de rotation d'ordre 4.

4. Élément d'imagerie selon l'une quelconque des revendications 1 à 3, dans lequel la pluralité des corps de structure (160) est disposée de telle manière que de la lumière d'une couleur correspondant audit pixel parmi la lumière incidente à l'extérieur d'une région en regard dudit pixel est également condensée sur ledit pixel.

5. Élément d'imagerie (12) selon l'une quelconque des revendications 1 à 4, comprenant en outre une couche de filtre fournie entre la pluralité de pixels et la couche transparente (150).

6. Dispositif d'imagerie (10), comprenant :
l'élément d'imagerie (12) selon l'une quelconque des revendications 1 à 5 ; et
une unité de traitement de signal (13) qui génère un signal d'image sur la base d'un signal électrique obtenu de l'élément d'imagerie (12).
